# EUROPEAN PATENT SPECIFICATION

(11) **EP 1 514 343 B1**
(45) Date of publication and mention of the grant of the patent: **28.10.2009**
(21) Application number: 03757224.5
(22) Date of filing: 21.05.2003
(51) Int. Cl.: H03B 5/32, G06F 1/06

(54) **AN ARRANGEMENT FOR LOW POWER CLOCK GENERATION**
ANORDNUNG ZUR TAKTGENERATION MIT NIEDRIGER LEISTUNG
AGENCEMENT DESTINE A UNE GENERATION D'HORLOGE A FAIBLE PUISSANCE

(30) Priority: 07.06.2002 SE 0201774
(43) Date of publication of application: 16.03.2005
(73) Proprietor: Infineon Technologies AG, 81669 München (DE)
(72) Inventor: DAHLIN, Jan, S-177 61 Järfälla (SE)
(74) Representative: Karlsson, Leif Karl Gunnar
(86) International application number: PCT/SE2003/000821
(87) International publication number: WO 2003/105333

(56) References cited:
- EP-A1- 0 515 182
- JP-A- 02 073 704
- US-A- 4 782 309
- PATENT ABSTRACTS OF JAPAN vol. 2002, no. 7 03 July 2002 & JP 2002 091606 A (SEIKO EPSON CORP) 29 March 2002
- PATENT ABSTRACTS OF JAPAN vol. 2000, no. 4 31 August 2000 & JP 2000 010651 A (MATSUSHITA ELECTRIC INC CO LTD) 14 January 2000
- PATENT ABSTRACTS OF JAPAN vol. 1997, no. 8 29 August 1997 & JP 09 102 714 A (ASAHI CHEMICAL MICRO SYSTEM) 15 April 1997

## Description

### TECHNICAL FIELD

The invention relates generally to clock signal oscillators and more specifically to an arrangement for low power clock signal generation in such oscillators.

### BACKGROUND OF THE INVENTION

In a radio transceiver in e.g. a Bluetooth system, a high frequency, e.g. 13 MHz, clock signal is needed for different operating modes such as transmit, receive, etc. Since high frequency accuracy, typically +/-10 ppm, is required in transmit and receive modes, this 13 MHz clock signal is generated by means of an accurate crystal oscillator. During sleep mode of the radio transceiver, i.e. when there are no transmit or receive operations, only a low frequency, e.g. 3.2 kHz, clock signal, with a lower frequency accuracy requirement, typically +/- 250 ppm, is needed and low power consumption is desired.

Publication EP 0 515 182 shows a low power crystal circuit where the power consumption during sleep mode is reduced by reducing the current to the amplifiers that provides the oscillator voltage to a level that maintains the oscillation of the crystal but that does not maintain the operational voltage swing of the output signal.

Publication JP 02 073704 shows a battery powered oscillation circuit, where a battery voltage detection circuit will reduce the capacity of a load capacitor of the oscillator at low battery power, thereby reducing the current consumption of the oscillator circuit and extending the battery replacement period.

It is known to generate the 3.2 kHz clock signal by means of a separate RC oscillator. However, even with trimming implemented RC oscillators have problems in achieving frequency accuracy over time and temperature.

It is also known to add a second crystal of a low frequency, e.g. 32 kHz, to create the 3.2 kHz clock signal. However, an additional crystal means additional costs.

Moreover, it is known to generate the 3.2 kHz clock signal by dividing the frequency of the 13 MHz clock signal. However, running the 13 MHz crystal oscillator at full power also in sleep mode would increase the power consumption of the radio transceiver too much.

### SUMMARY OF THE INVENTION

The object of the invention is to provide an arrangement for generating a clock signal with less power in a high accuracy crystal oscillator that comprises a gain stage controlled by a current from a current source, and a trimmable load capacitance.

This is attained by the arrangement according to the invention as defined in claim 1.

Hereby, the power consumption will be reduced.

### BRIEF DESCRIPTION OF THE DRAWING

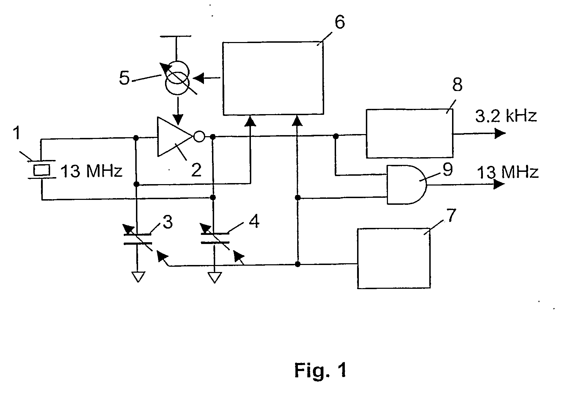

The invention will be described more in detail below with reference to the appended drawing on which Fig. 1 is a simplified schematic of an oscillator circuit with an embodiment of an arrangement according to the invention.

### DESCRIPTION OF THE INVENTION

Fig. 1 is a simplified schematic of a 13 MHz crystal oscillator circuit that comprises a crystal 1. The crystal 1 is connected with one of its terminals to an input terminal of a gain stage 2 and to ground via a trimmable load capacitance 3, and with its other terminals to an output terminal of the gain stage 2 and to ground via a trimmable load capacitance 4. By trimming the load capacitance 3, 4, high frequency accuracy, typically +/-10 ppm, is achieved.

The gain of the gain stage 2 is proportional to the current supplied by a variable current source 5 to the gain stage 2. In addition, the oscillation amplitude at the output of the gain stage 2 is a function of its gain, i.e. the higher gain, the higher oscillation amplitude.

In accordance with the invention, an oscillation amplitude regulator 6 is connected with its input terminal to the input terminal of the gain stage 2, with its output terminal to a control input terminal of the current source 5, and with a control input terminal to an output terminal of a mode control unit 7.

The oscillation amplitude is also a function of load capacitance, i.e. the less load capacitance, the higher oscillation amplitude is achieved for a certain gain. Therefore, the output terminal of the mode control unit 7 is also connected to control input terminals of the trimmable load capacitance 3, 4 making it possible to disconnect all or at least part of the load capacitance in sleep mode.

In the embodiment in Fig. 1, a frequency divider 8 is connected to the output terminal of the oscillator 2 to provide a 3.2 kHz clock signal. The divider 8 is running in all operating modes, including sleep mode, since the 3.2 kHz clock is needed all the time.

By means of the mode control unit 7, the oscillator circuit can be switched between an operating mode and a sleep mode.

In operating mode, i.e. when the 13 MHz clock signal is needed, the power consumption is high. This is due to the facts that the load capacitance needs to be trimmed to achieve the required frequency accuracy, and relatively high oscillation amplitude is needed for a low jitter of the 13 MHz clock signal.

In accordance with the invention, to reduce the power consumption of the oscillator circuit in sleep mode, i.e. when only the 3.2 kHz clock signal is needed, the mode control unit 7 is adapted to generate a control signal to disconnect at least part of the load capacitance 3, 4. By disconnecting part of the load capacitance 3, 4, less current will be needed from the current source 5 to the gain stage 2 to achieve a certain oscillation amplitude.

The load capacitance 3, 4 can be decreased since the accuracy requirements for the 3.2 kHz clock signal are relatively low, e.g. 250 ppm. The lesser load capacitance, the higher frequency error but less current is required for maintaining oscillation.

The control signal from the mode control unit 7 is also applied to the oscillation amplitude regulator 6 that is activated to reduce the current from the current source 5 to the gain stage 2 to such a value that oscillation is maintained with a minimum amplitude sufficient for proper frequency division performed by the divider 8.

The 13 MHz clock signal can be blocked in sleep mode by means of e.g. a gate. In the embodiment in Fig. 1, this is done by an AND gate 9 that is connected with its one input terminal to the output terminal of the gain stage 2 and with its other input terminal to the output terminal of the mode control unit 7.

## Claims

1. An arrangement for low power generation of a clock signal comprising a high accuracy crystal oscillator and a current source (5), the oscillator comprising a gain stage (2) controlled by a current from the current source (5), and a trimmable load capacitance (3, 4), **characterized in that** the arrangement comprises an oscillation amplitude regulator (6) and a mode control unit (7) for disconnecting at least part of the load capacitance (3, 4) and activating the oscillation amplitude regulator (6) that is connected between the input terminal of the gain stage (2) and the current source (5) to reduce the current to the gain stage (2) to such a value that oscillation is maintained with a minimum amplitude.

2. The arrangement according to claim 1, **characterized in that** the arrangement comprises a frequency divider (8) connected to the output terminal of the gain stage (2) to provide a low frequency clock signal.

3. The arrangement according to claim 2, **characterized in that** the arrangement comprises a gate (9) connected with its one input terminal to the output terminal of the gain stage (2) and with its other input terminal to the mode control unit (7) to block the output of the gate (9) when the low frequency clock signal is provided.

4. The arrangement according to claim 3, **characterized in that** the gate (9) is an AND gate.

## Patentansprüche

1. Eine Anordnung zur niederenergetischen Erzeugung eines Taktsignals, umfassend einen Kristalloszillator mit hoher Genauigkeit und eine Stromquelle (5), wobei der Oszillator eine Verstärkungsstufe (2), die durch einen Strom von dem Stromquelle (5) gesteuert wird, und eine trimmbaren Kapazität (3, 4) umfasst, **dadurch gekennzeichnet, dass** die Anordnung einen Oszillatiosamplitudenregulator (6) und eine Modensteuerungseinheit (7) umfasst zum Trennen von zumindest einem Teil der Belastungskapasität (3, 4) und zum Aktivieren des Oszillationsamplitudenregulators (6), der zwischen dem Eingangsanschluss der Verstärkerstufe (2) und der Stromquelle (5) verbunden ist, um den Strom zu der Verstärkerstufe (2) auf solch einen Wert zu reduzieren, dass die Oszillation mit einer minimalen Amplitude beibehalten wind.

2. Die Anordnung nach Anspruch 1, **dadurch gekennzeichnet, dass** die Anordnung einen Frequenzteiler (8) umfasst, der mit dem Ausgangsanschluss der Verstärkerstufe (2) verbunden ist, zum Bereitstellen eines niederfrequenten Taktsignals.

3. Die Anordnung nach Anspruch 2, **dadurch gekennzeichnet, dass** die Anordnung ein Gatter (9) umfasst, das mit dessen einem Eingangsanschluss mit dem Ausgangsanschluss der Verstärkerstufe (2) und mit dessen anderen Eingangsanschluss mit der Modensteuerungseinheit (7) verbunden ist, zum Blockieren der Ausgabe des Gatters (9), wenn das niederfrequente Taktsignal bereitgestellt wird.

4. Die Anordnung nach Anspruch 3, **dadurch gekennzeichnet, dass** das Gatter (9) ein UND-Gatter ist.

## Revendications

1. Agencement de génération à faible puissance d'un signal d'horloge comprenant un oscillateur à quartz de grande précision et une source de courant (5), l'oscillateur comprenant un étage de gain (2) commandé par un courant provenant de la source de courant (5), et une capacitance de charge (3, 4) ajustable, **caractérisé en ce que** l'agencement comprend un régulateur d'amplitude d'oscillation (6) et une unité de commande de mode (7) pour déconnecter au moins une partie de la capacitance de charge (3, 4) et activer le régulateur d'amplitude d'oscillation (6) qui est connecté entre la borne d'entrée de l'étage de gain (2) et la source de courant (5) pour réduire le courant vers l'étage de gain (2) à une valeur telle que l'oscillation est maintenue à une amplitude minimum.

2. Agencement selon la revendication 1, **caractérisé en ce que** l'agencement comprend un diviseur de fréquence (8) connecté à la borne de sortie de l'étage de gain (2) pour fournir un signal d'horloge de faible fréquence.

3. Agencement selon la revendication 2, **caractérisé en ce que** l'agencement comprend une porte (9) connectée, à sa borne d'entrée, à la borne de sortie de l'étage de gain (2) et, à son autre borne d'entrée, à l'unité de commande de mode (7) pour bloquer la sortie de la porte (9) lorsque le signal d'horloge de faible fréquence est fourni.

4. Agencement selon la revendication 3, **caractérisé en ce que** la porte (9) est une porte ET.
